# EUROPÄISCHE PATENTANMELDUNG

(11) **EP 3 312 860 A1**
(43) Veröffentlichungstag der Anmeldung: **25.04.2018**
(21) Anmeldenummer: 16195383.1
(22) Anmeldetag: 24.10.2016
(51) Int. Cl.: H01H 9/04, G05B 19/409, G06F 3/046

(54) **ANORDNUNG ZUM BERÜHRUNGSLOSEN BEDIENEN EINES GERÄTS DER MESSTECHNIK MIT EINER EIN- UND AUSGABEEINHEIT UND VERFAHREN ZUM BETREIBEN EINER EIN- UND AUSGABEEINHEIT EINES GERÄTS DER MESSTECHNIK**

(71) Anmelder: VEGA Grieshaber KG, 77709 Wolfach (DE)
(72) Erfinder: Lienhard, Jürgen, 77716 Fischerbach (DE)
(74) Vertreter: Westphal, Mussgnug & Partner Patentanwälte mbB

(57) **Zusammenfassung**

Anordnung zum berührungslosen bedienen eines Geräts der Messtechnik (1) mit einer Ein- und Ausgabeeinheit (5), die wenigstens
- eine Steuereinheit (7)
- eine mit der Steuereinheit (7) gekoppelten Anzeigeeinheit (9) und
- ein mit der Steuereinheit (7) gekoppeltes Eingabegerät (11) umfasst, wobei das Eingabegerät (11) wenigstens einen Magnetfeldsensor (13) mit dreidimensionaler Magnetfelderfassung und ein mit dem Magnetfeldsensor (13) zusammenwirkendes magnetisches Bedienelement (15) aufweist.

## Beschreibung

Anordnung zum berührungslosen Bedienen eines Geräts der Messtechnik mit einer Ein- und Ausgabeeinheit und Verfahren zum Betreiben einer Ein- und Ausgabeeinheit eines Geräts der Messtechnik.

Die vorliegende Erfindung betrifft eine Anordnung zum berührungslosen Bedienen eines Geräts der Messtechnik mit einer Ein- und Ausgabeeinheit gemäß dem Oberbegriff des Patentanspruchs 1 sowie ein Verfahren zum Betreiben einer Ein- und Ausgabeeinheit eines Geräts der Messtechnik gemäß Patentanspruch 9.

Anordnungen zum berührungslosen Bedienen eines Geräts der Messtechnik mit einer Ein- und Ausgabeeinheit sind aus dem Stand der Technik beispielsweise für Feldgeräte bekannt und werden unter anderem bei der Füllstand-, Druck- und Grenzstandmessung in Umgebungen mit erhöhten Anforderungen an die Schutzklasse der Geräte eingesetzt.

Derartige Feldgeräte mit Ein- und Ausgabeeinheiten sind aus dem Stand der Technik beispielsweise aus der DE 37 34 494 bekannt, die eine explosionssichere Steueranordnung beschreibt, bei der eine Gruppe von Dateneingabe/-taststellen eine Gruppe von mit den Taststellen ausgerichteten, magnetisch betätigbaren Sensoren zugeordnet ist. Bei dieser aus dem Stand der Technik bekannten Anordnung ist jeweils einer Eingabetaste ein magnetisch betätigbarer Sensor zugeordnet und unmittelbar unterhalb dieser platziert. Wenn es nunmehr notwendig ist, an der Steueranordnung, die in einem explosionssicheren Gehäuse angeordnet ist, eine Eingabe zu tätigen, so kann dies mittels eines Permanentmagneten mittels dessen die magnetisch betätigbaren Sensoren aktivierbar sind, erfolgen.

Bei den im Stand der Technik typischerweise eingesetzten Magnetfeldsensoren, die typischerweise als Reed-Kontakte oder Hall-Sensoren ausgebildet sind, ist lediglich eine Detektion eines Magnetfelds über- oder unterhalb eines Schwellwertes, jedoch nicht eine Detektion der Orientierung beziehungsweise einer Feldstärkeverteilung im dreidimensionalen Raum möglich. Auf diese Weise ist daher nur eine Ja/Nein beziehungsweise 0/1 Entscheidung mittels eines solchen Sensors realisierbar, was die Flexibilität und Einsatzfähigkeit solcher Ein- und Ausgabeeinheiten deutlich einschränkt.

An diesen aus dem Stand der Technik bekannten Anordnungen wird es als nachteilig empfunden, dass jeweils nur die Betätigung einer Taste möglich ist und die Eingabe damit sehr unflexibel ist.

Alternative Möglichkeiten zur Bedienung von Eingabegeräten von Feldgeräten aus dem Stand der Technik sind beispielsweise eine kapazitive Eingabe, wie sie beispielsweise bei modernen Smartphones und Tablet-PCs verwendet wird oder das Abscannen eines Feldes auf Infrarotstrahlung. Kapazitive Eingaben sin allerdings in der Distanz, auf die eine Bedienung erfolgen kann, sehr eingeschränkt und das Abscannen von Feldern auf Infrarotstrahlung ist in eingebetteten Systemen, wie sie bei Feldgeräten typischerweise zum Einsatz kommen, sehr rechenaufwändig. Beide Systeme sind daher nicht oder nur bedingt einsetzbar. Weiterhin sind Systeme, welche mittels Infrarot arbeiten, aufgrund von auftretenden Verschmutzungen sehr anfällig.

Es ist die Aufgabe der vorliegenden Erfindung einer Anordnung zum berührungslosen Bedienen eines Geräts der Messtechnik mit einer Ein- und Ausgabeeinheit derart weiterzubilden, dass die Bedienung des Geräts flexibler und gleichzeitig intuitiv möglich ist. Ferner ist es eine Aufgabe der vorliegenden Erfindung, ein Verfahren zum Betreiben einer solchen Ein- und Ausgabeeinheit anzugeben.

Eine erfindungsgemäße Anordnung zum berührungslosen Bedienen eines Geräts der Messtechnik, insbesondere eines Feldgeräts der Füllstand-, Druck- oder Grenzstandmesstechnik weist eine Ein- und Ausgabeeinheit auf, die wenigstens eine Steuereinheit, eine mit der Steuereinheit gekoppelte Anzeigeeinheit und ein mit der Steuereinheit gekoppeltes Eingabegerät umfasst, wobei das Eingabegerät wenigstens einen Magnetfeldsensor mit dreidimensionaler Magnetfelderfassung und ein mit dem Magnetfeldsensor zusammenwirkendes magnetisches Bedienelement aufweist.

Durch die Verwendung wenigstens eines Magnetfeldsensors mit dreidimensionaler Magnetfelderfassung sowie eines mit dem Magnetfeldsensor zusammenwirkenden magnetischen Bedienelements wird eine Magnetfelderfassung in sämtlichen Raumrichtungen möglich, sodass mit Hilfe des magnetischen Bedienelements eine Bedienung des Geräts ähnlich der Bedienung eines Computers mit einer Maus oder eines Track-Pads, jedoch berührungslos erreicht werden kann. Es kann damit eine graphische Repräsentanz einer Position des magnetischen Bedienelements auf dem Anzeigegerät in Form eines Cursors oder Mauszeigers ähnlich der Bedienung eines Computers bewegt und damit sehr intuitiv eine Eingabe realisiert werden.

Eine besonders günstige Realisierung bei gleichzeitig hervorragenden Eigenschaften hinsichtlich Ortsauflösung und Stromverbrauch wird bei Einsatz eines Kompasssensors, beispielsweise eine Magnetometers mit magneto-resistiven Sensoren für eine Dreiachsen-Magnetfelderkennung möglich. Solche Kompasssensoren werden in Massenanwendungen wie Smartphones, Tablet-Computern und dergleichen eingesetzt und sind daher sehr günstig. Ferner sind solche Sensoren mit einem sehr hohen Miniaturisierungsgrad, einer hohen Auflösung der Messwerte in sämtliche Raumrichtungen, einem großen und einstellbaren Messbereich sowie mit geringem Leistungsbedarf verfügbar.

Die vorliegende Anordnung eignet sich besonders für den Einsatz in staubgeschützten und/oder wasserdichten und/oder explosionssicheren Gehäusen, sodass in entsprechenden staubund/oder wasser- und/oder explosionsgefährdeten Umgebungen ein Einsatz der Anordnung möglich ist. Insbesondere ist es hierbei möglich, dass der Magnetfeldsensor und die Anzeigeeinheit in einem Gehäuse entsprechender Schutzklasse angeordnet sind und eine berührungslose Bedienung mit Hilfe des magnetischen Bedienelements von außerhalb des Gehäuses möglich ist.

Die Anordnung kann ferner eine Präsenzerkennung des Bedienelements aufweisen, sodass die Ein- und Ausgabeeinheit, und insbesondere die Anzeigeeinheit nur dann in einen Bedienmodus mit erhöhtem Energieverbrauch überführt werden, wenn eine Präsenz des Bedienelements in einem Erfassungsbereich des Magnetfeldsensors erkannt wird. Beispielsweise kann in einem Ruhemodus eine Abtastrate des Magnetfeldsensors deutlich reduziert und die Anzeigeeinheit deaktiviert sein. Wird das magnetische Bedienelement in den Erfassungsbereich des Magnetfeldsensors verbracht und dementsprechend eine Anwesenheit des magnetischen Bedienelements im Erfassungsbereich erkannt, so kann das Feldgerät in den Bedienmodus mit erhöhter Abtastrate und aktivierter Anzeigeeinheit überführt werden.

Eine intuitive, zielgerichtete und präzise Bedienung kann dadurch erreicht werden, dass das Bedienelement die Form eines Stiftes aufweist.

Die magnetischen Eigenschaften des Bedienelements können beispielsweise durch einen Permanentmagneten, einen Elektromagneten oder eine Kombination aus einem Permanentmagneten und einem Elektromagneten erreicht werden.

Mit Hilfe eines Permanentmagneten kann ein sehr einfach aufgebautes und robustes magnetisches Bedienelement zur Verfügung gestellt werden, wohingegen mit Hilfe eines Elektromagneten oder einer Kombination aus Elektromagnet und Permanentmagnet eine aktive Eingabe, beispielsweise durch Modulation der Feldstärke, durch Änderung einer Polarisation oder andere geeignete Beeinflussungen des Magnetfelds eine aktive Eingabe erreicht werden kann. Der Permanentmagnet, der Elektromagnet oder die Kombination aus Permanent- und Elektromagnet weist dabei vorzugsweise in einem Abstand von 1 cm eine Flussdichte zwischen 0,025 mT und 50 mT, vorzugsweise von wenigstens 0,1 mT auf.

Auf diese Weise wird eine zuverlässige Bedienung des Eingabegeräts auch in einem Abstand von mehreren Zentimetern und durch Gehäuse entsprechender Schutzklassen, die typischerweise dicke Glasscheiben zum Explosionsschutz aufweisen, gewährleistet.

Um eine optimale Verwendbarkeit der Anordnung zu gewährleisten, kann es sinnvoll sein, wenn diese ein Modul oder eine Funktionalität zur Autokalibrierung aufweist. Auf diese Weise können störende Magnetfelder, bspw. das Erdmagnetfeld aber auch Störeinflüsse anderer magnetischer Komponenten ausgeblendet werden.

Vorteilhafterweise ist die Steuereinheit der vorliegenden Anordnung derart ausgebildet, dass ein Verweilen des Bedienelements innerhalb eines vorgegebenen Bereichs oder eine kurzzeitige Veränderung einer Stärke und/oder Polarität eines an dem Magnetfeldsensor erfassten Magnetfelds als eine Bestätigung einer Eingabe interpretiert wird.

Ein Verweilen des Bedienelements innerhalb eines vorgegebenen Bereichs kann beispielsweise dann erkannt werden, wenn die graphische Repräsentanz des Bedienelements auf der Anzeige innerhalb eines dort graphisch gekennzeichneten Feldes platziert und das Bedienelement dann für ein vorgegebene Zeitdauer nicht mehr oder nur geringfügig bewegt wird. Alternativ kann bei einer entsprechenden Platzierung des Mauszeigers eine Veränderung der Stärke des Magnetfelds durch ein kurzzeitiges Annähern des Bedienelements in Richtung des Magnetfeldsensors als Bestätigung einer Eingabe gewertet werden. Bei Einsatz eines Elektromagneten kann eine Änderung der Stärke des Magnetfelds durch kurzzeitige Erhöhung des fließenden Stroms oder eine Änderung der Polarität durch ein Umpolen des Elektromagneten ebenfalls zur Bestätigung einer Eingabe verwendet werden.

Dasselbe gilt für eine Kombination aus Permanent- und Elektromagneten.

Bei einem Verfahren zum Betreiben einer Ein- und Ausgabeeinheit eines Geräts der Messtechnik, bei dem die Ein- und Ausgabeeinheit wenigstens eine Steuereinheit, eine mit der Steuereinheit gekoppelte Anzeigeeinheit und ein mit der Steuereinheit gekoppeltes Eingabegerät aufweist und wobei ferner das Eingabegerät wenigstens einen Magnetfeldsensor mit dreidimensionaler Magnetfelderfassung und ein mit dem Magnetfeldsensor zusammenwirkendes magnetisches Bedienelement aufweist, wird eine Positionierung und/oder Bewegung des Bedienelements in einem Erfassungsbereich des Magnetfeldsensors erkannt und in eine korrespondierende stufenlose Bewegung und/oder Position einer graphischen Repräsentanz des Bedienelements auf der Anzeigeeinheit überführt.

Durch ein Verfahren, bei dem eine Positionierung und/oder Bewegung des Bedienelements in einem Erfassungsbereich des Magnetfeldsensors erkannt und in eine korrespondierende stufenlose Bewegung und/oder Position einer graphischen Repräsentanz des Bedienelements, insbesondere eines Mauszeigers oder Cursors, überführt wird, wird eine intuitive flexible Bedienung eines entsprechenden Geräts der Messtechnik, insbesondere Feldgeräts der Füllstand-, Druck- oder Grenzstandmessung ermöglicht. Insbesondere wird es dadurch ermöglicht, dass für eine Bedienung unterschiedlicher Menüebenen mit unterschiedlichen Eingabemasken frei angepasst werden können. Durch ein entsprechendes Verfahren wird es ferner ermöglicht, nicht nur eine Anpassung der Eingabemasken vorzunehmen, sondern auch komplexere Eingaben, beispielsweise eine Handschrifterkennung oder die Erkennung einfacher Gesten, die mit dem Bedienelement ausgeführt werden, zu implementieren.

Eine Energieersparnis kann erreicht werden, wenn die Ein- und Ausgabeeinheit nach einer vorgegebenen Zeit ohne Eingabe oder auf Anwenderbefehl von einem Bedienmodus in einen Ruhemodus überführt wird. In einem Ruhemodus kann beispielsweise eine Abtastfrequenz des verwendeten Magnetfeldsensors reduziert und/oder die Anzeigeeinheit, beispielsweise ein pixelbasiertes Display, deaktiviert werden.

Wird dann das Bedienelement wieder in einen vorgegebenen Erfassungsbereich des Magnetfeldsensors verbracht, so kann die Ein- und Ausgabeeinheit wieder aus dem Ruhemodus in einen Bedienmodus, beispielsweise mit aktivierter Anzeigeeinheit und erhöhter Abtastrate des Magnetfeldsensors, überführt werden.

Bei dem vorliegenden Verfahren kann eine Eingabe beziehungsweise eine Bestätigung einer Eingabe dadurch erfolgen, dass ein Verweilen des Bedienelements beziehungsweise der graphischen Repräsentanz für eine vorgegebene Zeit an einer Position innerhalb des Erfassungsbereichs als Bestätigung interpretiert wird. So kann beispielsweise eine zu einem Tastendruck korrespondierende Eingabe dadurch implementiert werden, dass eine Aktivierung einer auf der Anzeigeeinheit eingeblendeten Taste dann angenommen wird, wenn der Cursor für eine vorgegebene Zeit innerhalb des eingeblendeten Tastenfelds verweilt.

Eine solche Eingabe kann für den Nutzer beispielsweise dadurch intuitiv gestaltet werden, dass die Verweildauer des Cursors innerhalb des vorgegebenen Bereichs graphisch angezeigt wird. So kann beispielsweise eine angewählte Taste, abhängig von der Verweildauer des Cursors auf dieser Taste, farbig gekennzeichnet oder in Art einer Balkenanzeige gefüllt werden. Alternativ kann im Bedienmodus ein kurzzeitiges Verändern des am Magnetfeldsensor erfassten Magnetfelds, insbesondere ein Verändern einer Feldstärke und/oder einer Polarität des Magnetfelds als Bestätigung einer Eingabe interpretiert werden.

Für unterschiedliche Eingabearten, beispielsweise das Drücken von eingeblendeten Tasten einerseits oder eine Schrifterkennung andererseits, kann es sinnvoll sein, wenn eine Abtastrate des Magnetfeldsensors anpassbar ist.

Ebenfalls erfindungsgemäß ist ein Gerät der Messtechnik mit einer Anordnung zur berührungslosen Bedienung gemäß einem der Ansprüche 1 bis 8 die gemäß einem Verfahren gemäß einem der Ansprüche 9 bis 15 betrieben wird.

Die vorliegende Erfindung wird nachfolgend anhand eines Ausführungsbeispiels unter Bezugnahme auf die beigefügten Figuren eingehend erläutert. Es zeigen:
- Figur 1: eine schematische Darstellung eine Geräts der Messtechnik gemäß der vorliegenden Anmeldung und
- Figur 2: die Anzeigeeinheit des Geräts aus Figur 1 in vergrößerter Darstellung.

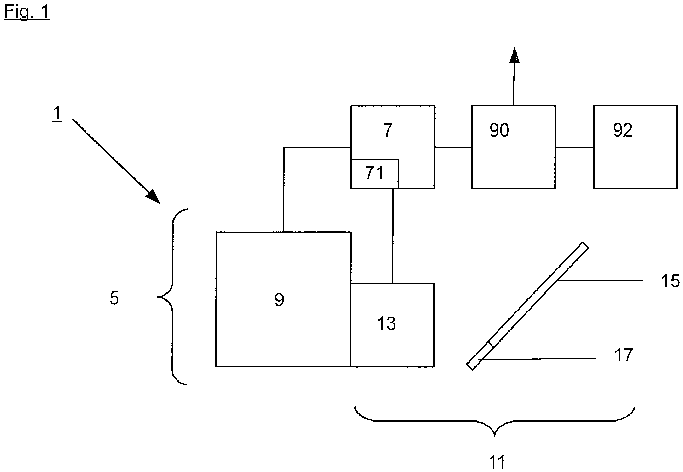

Figur 1 zeigt eine schematische Darstellung eines Geräts der Messtechnik 1, das beispielsweise ein Feldgerät, insbesondere ein Füllstandmessgerät, ein Druckmessgerät oder ein Grenzstandmessgerät sein kann. Das Gerät der Messtechnik 1 weist eine Ein- und Ausgabeeinheit 5, die mit einer Sensorelektronik 90 und einem damit verbundenen Sensor 92 zusammenwirkt, auf. Der Sensor 92 ist dabei mit der Geräteelektronik 90, die beispielsweise mit einem Leitstand verbunden sein kann, verbunden. Zur Konfiguration der Geräteelektronik 90 und zur Ausgabe von Messwerten auf einer Anzeigeeinheit 9 ist die Geräteelektronik 90 ferner mit der Ein- und Ausgabeeinheit 5 verbunden.

Die Ein- und Ausgabeeinheit 5 ist im Wesentlichen aus einer Steuereinheit 7, einer mit der Steuereinheit 7 gekoppelten Anzeigeeinheit sowie einem ebenfalls mit der Steuereinheit 7 gekoppelten Eingabegerät 11 gebildet. Das Eingabegerät 11 ist im vorliegenden Ausführungsbeispiel zweiteilig ausgestaltet, wobei ein Magnetfeldsensor 13 mit einer dreidimensionalen Magnetfelderfassung mit der Steuereinheit 7 verbunden ist. Ein Bedienelement 15, das vorliegend stiftförmig ausgestaltet und mit einem Permanentmagneten 17 versehen ist, ist als separate Einheit ausgestaltet und dient zur berührungslosen Bedienung der Ein- und Ausgabeeinheit 5 und damit auch des Geräts der Messtechnik 1.

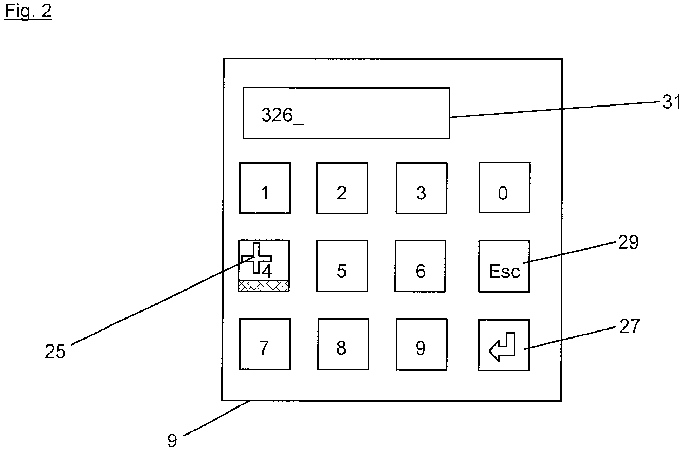

In Figur 2 ist eine vergrößerte Darstellung der Anzeigeeinheit 9 des Geräts der Messtechnik 1 aus Figur 1 gezeigt. In Figur 2 ist eine mögliche Ausgestaltung einer Anzeige, wie sie auf der Anzeigeeinheit 9 dargestellt werden kann, gezeigt. In dem in Figur 2 dargestellten Beispiel ist ein Ziffernblock mit Ziffern von 0 bis 9, eine Bestätigungstaste 27 sowie eine Abbruchtaste 29 dargestellt und zusätzlich ein Eingabefeld 31 für die Darstellung einer eingegebenen Ziffernfolge dargestellt.

Im Bereich der eingeblendeten Taste mit der Ziffer "4" ist ferner eine graphische Repräsentanz 25 des Bedienelements 15, vorliegend als Kreuz dargestellt, gezeigt. Durch Verweilen der graphischen Repräsentanz 25 im Bereich der eingeblendeten Taste wird eine Eingabe ausgelöst. Graphisch wird dies durch ein allmähliches Auffüllen des eingeblendeten Ziffernfelds mit einer kreuzschraffiert dargestellten Füllung gekennzeichnet. Ist das Ziffernfeld vollständig mit der Füllung ausgefüllt, so wird dies als Eingabe gewertet und die entsprechende Ziffer im oben dargestellten Eingabefeld 31 angezeigt.

Bei der entsprechend hohen Auflösung des Magnetfeldsensors kann ferner eine Handschrift- und/oder Gestenerkennung bei der Eingabe mit dem magnetischen Bedienelement 15 implementiert werden. Dies stellt eine zusätzliche oder alternative Eingabemethode dar. Durch ein entsprechend stark magnetisiertes Bedienelement 15 oder einen entsprechend starken in dem Bedienelement 15 angeordneten Elektromagneten 19 kann eine Bedienung auch durch beispielsweise dicke Glasscheiben oder Gehäuseteile hindurch - solange diese nicht auch magnetisch sind - erfolgen. Auf diese Weise können sämtliche Komponenten des Geräts der Messtechnik 1 in einem staub-, wasser- oder explosionsgeschützten Gehäuse angeordnet sein und damit ein Einsatz des entsprechenden Geräts in Umgebungen für Geräte mit entsprechenden Schutzklassen ermöglicht werden.

### Bezugszeichenliste

- 1: Gerät der Messtechnik
- 5: Ein- und Ausgabeeinheit
- 7: Steuereinheit
- 9: Anzeigeeinheit

- 11: Eingabegerät
- 13: Magnetfeldsensor
- 15: Bedienelement
- 17: Permanentmagnet
- 19: Elektromagnet

- 25: Repräsentanz
- 27: Eingabetaste
- 29: Abbruchtaste

- 31: Eingabefeld

- 71: Bedienelementerkennung

- 90: Geräteelektronik
- 92: Sensor

## Patentansprüche

1. Anordnung zum berührungslosen bedienen eines Geräts der Messtechnik (1) mit einer Ein- und Ausgabeeinheit (5), die wenigstens
- eine Steuereinheit (7)
- eine mit der Steuereinheit (7) gekoppelten Anzeigeeinheit (9) und
- ein mit der Steuereinheit (7) gekoppeltes Eingabegerät (11) umfasst,
**dadurch gekennzeichnet, dass**
das Eingabegerät (11) wenigstens einen Magnetfeldsensor (13) mit dreidimensionaler Magnetfelderfassung und ein mit dem Magnetfeldsensor (13) zusammenwirkendes magnetisches Bedienelement (15) aufweist.

2. Anordnung gemäß Anspruch 1,
**dadurch gekennzeichnet, dass**
der Magnetfeldsensor (13) als Drei-Achsen-Magnetometer ausgebildet ist.

3. Anordnung gemäß Anspruch 2,
**dadurch gekennzeichnet, dass**
der Magnetfeldsensor (13) und die Anzeigeeinheit (9) in einem staubgeschützten und/oder wasserdichten und/oder explosionssicheren Gehäuse angeordnet sind.

4. Anordnung gemäß einem der vorhergehenden Ansprüche,
**dadurch gekennzeichnet, dass**
die Anordnung eine Bedienelementerkennung (71) aufweist.

5. Anordung gemäß Anspruch 4,
**dadurch gekennzeichnet,**
**dass** die Bedienelementerkennung (71) in die Steuereinheit (7) integriert ist, die durch Auswertung der Signale des Magnetfeldsensors (13) die Präsenz eines Bedienelementes (15) erkennt.

6. Anordnung gemäß einem der vorhergehenden Ansprüche,
**dadurch gekennzeichnet, dass**
das Bedienelement (15) die Form eines Stiftes aufweist.

7. Anordnung gemäß Anspruch 6,
**dadurch gekennzeichnet, dass**
das Bedienelement (15) einen Permanentmagneten (17) oder einen Elektromagneten (19) oder eine Kombination daraus aufweist.

8. Anordnung gemäß Anspruch 7,
**dadurch gekennzeichnet, dass** das Bedienelement (15) in einem Abstand von 1 cm in Axialrichtung eine Flussdichte zwischen 0,025 mT und 50 mT, vorzugsweisevon wenigstens 0,1 mT aufweist.

9. Anordnung gemäß einem der vorhergehenden Ansprüche,
**dadurch gekennzeichnet, dass**
die Steuereinheit (7) derart ausgebildet ist, dass ein Verweilen des Bedienelements (15) innerhalb eines vorgegebenen Bereichs oder eine kurzzeitige Veränderung einer Stärke und/oder Polarität eines an dem Magnetfeldsensor (13) erfassten Magnetfelds als eine Bestätigung einer Eingabe interpretiert wird.

10. Verfahren zur Betreiben einer Ein- und Ausgabeeinheit (5) eines Geräts der Messtechnik, wobei die Ein- und Ausgabeeinheit (5) wenigstens eine Steuereinheit (7), eine mit der Steuereinheit (7) gekoppelten Anzeigeeinheit (9) und ein mit der Steuereinheit (7) gekoppeltes Eingabegerät (11) aufweist, wobei ferner das Eingabegerät (11) wenigstens einen Magnetfeldsensor (13) mit dreidimensionaler Magnetfelderfassung und ein mit dem Magnetfeldsensor (13) zusammenwirkendes magnetisches Bedienelement (15) aufweist, wobei bei dem Verfahren eine Positionierung und/oder Bewegung des Bedienelements (15) in einem Erfassungsbereich des Magnetfeldsensors (13) erkannt und in eine korrespondierende stufenlose Bewegung und/oder Position einer graphischen Repräsentanz (25) des Bedienelements (15) auf der Anzeigeeinheit (9) überführt wird.

11. Verfahren gemäß Anspruch 10, bei dem die Ein- und Ausgabeeinheit (5) nach einer vorgegebenen Zeit ohne Eingabe oder auf Anwenderbefehl von einem Bedienmodus in einen Ruhemodus überführt wird.

12. Verfahren gemäß einem der Ansprüche 10 oder 11, bei dem die Ein- und Ausgabeeinheit (5) bei Verbringung des Bedienelements (15) in einen vorgegebenen Erfassungsbereich aus einem Ruhemodus in einen Bedienmodus überführt wird.

13. Verfahren gemäß einem der Ansprüche 10 bis 12, bei dem im Bedienmodus ein Verweilen des Bedienelements (15) bzw. der graphischen Repräsentanz (25) für eine vorgegebene Zeit an einer Position innerhalb des Erfassungsbereichs als Bestätigung einer Eingabe interpretiert wird.

14. Verfahren gemäß Anspruch 13, bei dem die Verweildauer graphisch angezeigt wird.

15. Verfahren gemäß einem der Ansprüche 10 bis 12, bei dem im Bedienmodus eine kurzzeitige Veränderung des am Magnetfeldsensor (13) erfassten Magnetfeldes, insbesondere einer Feldstärke und/oder einer Polarität als Bestätigung einer Eingabe interpretiert wird.

16. Verfahren gemäß einem der Ansprüche 10 bis 15, bei dem eine Abtastrate des Magnetfeldsensors (13) anpassbar ist.

17. Gerät der Messtechnik mit einer Anordnung zur berührungslosen Bedienung gemäß einem der Ansprüche 1 bis 9, die gemäß einem Verfahren gemäß einem der Ansprüche 10 bis 16 betrieben wird.

## Geänderte Patentansprüche

### Geänderte Patentansprüche gemäss Regel 137(2) EPÜ.

1. Anordnung zum berührungslosen bedienen eines Geräts der Messtechnik (1) mit einer Ein- und Ausgabeeinheit (5), die wenigstens
- eine Steuereinheit (7)
- eine mit der Steuereinheit (7) gekoppelten Anzeigeeinheit (9) und
- ein mit der Steuereinheit (7) gekoppeltes Eingabegerät (11) umfasst,
das Eingabegerät (11) wenigstens einen Magnetfeldsensor (13) und ein mit dem Magnetfeldsensor zusammenwirkendes magnetisches Bedienelement aufweist,
**dadurch gekennzeichnet, dass**
der Magnetfeldsensor (13) ein Magnetfeldsensor (13) mit dreidimensionaler Magnetfelderfassung ist.

2. Anordnung gemäß Anspruch 1,
**dadurch gekennzeichnet, dass**
der Magnetfeldsensor (13) als Drei-Achsen-Magnetometer ausgebildet ist.

3. Anordnung gemäß Anspruch 2,
**dadurch gekennzeichnet dass**
der Magnetfeldsensor (13) und die Anzeigeeinheit (9) in einem staubgeschützten und/oder wasserdichten und/oder explosionssicheren Gehäuse angeordnet sind.

4. Anordnung gemäß einem der vorhergehenden Ansprüche,
**dadurch gekennzeichnet, dass**
die Anordnung eine Bedienelementerkennung (71) aufweist.

5. Anordung gemäß Anspruch 4,
**dadurch gekennzeichnet,**
**dass** die Bedienelementerkennung (71) in die Steuereinheit (7) integriert ist, die durch Auswertung der Signale des Magnetfeldsensors (13) die Präsenz eines Bedienelementes (15) erkennt.

6. Anordnung gemäß einem der vorhergehenden Ansprüche,
**dadurch gekennzeichnet, dass**
das Bedienelement (15) die Form eines Stiftes aufweist.

7. Anordnung gemäß Anspruch 6,
**dadurch gekennzeichnet, dass**
das Bedienelement (15) einen Permanentmagneten (17) oder einen Elektromagneten (19) oder eine Kombination daraus aufweist.

8. Anordnung gemäß Anspruch 7,
**dadurch gekennzeichnet, dass** das Bedienelement (15) in einem Abstand von 1 cm in Axialrichtung eine Flussdichte zwischen 0,025 mT und 50 mT, vorzugsweisevon wenigstens 0,1 mT aufweist.

9. Anordnung gemäß einem der vorhergehenden Ansprüche,
**dadurch gekennzeichnet, dass**
die Steuereinheit (7) derart ausgebildet ist, dass ein Verweilen des Bedienelements (15) innerhalb eines vorgegebenen Bereichs oder eine kurzzeitige Veränderung einer Stärke und/oder Polarität eines an dem Magnetfeldsensor (13) erfassten Magnetfelds als eine Bestätigung einer Eingabe interpretiert wird.

10. Verfahren zur Betreiben einer Ein- und Ausgabeeinheit (5) eines Geräts der Messtechnik, wobei die Ein- und Ausgabeeinheit (5) wenigstens eine Steuereinheit (7), eine mit der Steuereinheit (7) gekoppelten Anzeigeeinheit (9) und ein mit der Steuereinheit (7) gekoppeltes Eingabegerät (11) aufweist, wobei ferner das Eingabegerät (11) wenigstens einen Magnetfeldsensor (13) und ein mit dem Magnetfeldsensor (13) zusammenwirkendes magnetisches Bedienelement (15) aufweist, wobei bei dem Verfahren eine Positionierung und/oder Bewegung des Bedienelements (15) in einem Erfassungsbereich des Magnetfeldsensors (13) erkannt,
**dadurch gekennzeichnet, dass**
der Magnetsensor (13) ein Magnetfeldsensor (13) mit dreidimensionaler Magnetfelderfassung ist und die Positionierung und/oder Bewegung des Bedienelements (15) in eine korrespondierende stufenlose Bewegung und/oder Position einer graphischen Repräsentanz (25) des Bedienelements (15) auf der Anzeigeeinheit (9) überführt wird.

11. Verfahren gemäß Anspruch 10, bei dem die Ein- und Ausgabeeinheit (5) nach einer vorgegebenen Zeit ohne Eingabe oder auf Anwenderbefehl von einem Bedienmodus in einen Ruhemodus überführt wird.

12. Verfahren gemäß einem der Ansprüche 10 oder 11, bei dem die Ein- und Ausgabeeinheit (5) bei Verbringung des Bedienelements (15) in einen vorgegebenen Erfassungsbereich aus einem Ruhemodus in einen Bedienmodus überführt wird.

13. Verfahren gemäß einem der Ansprüche 10 bis 12, bei dem im Bedienmodus ein Verweilen des Bedienelements (15) bzw. der graphischen Repräsentanz (25) für eine vorgegebene Zeit an einer Position innerhalb des Erfassungsbereichs als Bestätigung einer Eingabe interpretiert wird.

14. Verfahren gemäß Anspruch 13, bei dem die Verweildauer graphisch angezeigt wird.

15. Verfahren gemäß einem der Ansprüche 10 bis 12, bei dem im Bedienmodus eine kurzzeitige Veränderung des am Magnetfeldsensor (13) erfassten Magnetfeldes, insbesondere einer Feldstärke und/oder einer Polarität als Bestätigung einer Eingabe interpretiert wird.

16. Verfahren gemäß einem der Ansprüche 10 bis 15, bei dem eine Abtastrate des Magnetfeldsensors (13) anpassbar ist.

17. Gerät der Messtechnik mit einer Anordnung zur berührungslosen Bedienung gemäß einem der Ansprüche 1 bis 9, die gemäß einem Verfahren gemäß einem der Ansprüche 10 bis 16 betrieben wird.
